# EUROPEAN PATENT SPECIFICATION

(11) **EP 2 936 952 B1**
(45) Date of publication and mention of the grant of the patent: **05.12.2018**
(21) Application number: 12890202.0
(22) Date of filing: 18.12.2012
(51) Int. Cl.: H05K 7/20, F24F 11/00, F24F 13/30

(54) **COOLING UNIT AND METHOD**
KÜHLEINHEIT UND VERFAHREN
UNITÉ ET PROCÉDÉ DE REFROIDISSEMENT

(43) Date of publication of application: 28.10.2015
(73) Proprietor: Schneider Electric IT Corporation, West Kingston, RI 02892 (US)
(72) Inventor: LONG, Rong, Minhang Shanghai 201108 (CN); MENG, Qiang, Minhang Shanghai 201108 (CN); NI, Jiujian, Pudong Shanghai 200120 (CN)
(74) Representative: Murgitroyd & Company
(86) International application number: PCT/CN2012/086803
(87) International publication number: WO 2014/094215

(56) References cited:
- EP-A1- 0 025 665
- EP-A1- 0 767 601
- CN-A- 101 437 385
- CN-A- 102 422 230
- CN-A- 102 461 357
- CN-A- 102 791 110
- US-A1- 2008 198 549
- US-A1- 2011 292 595
- US-A1- 2011 292 600
- US-B1- 7 165 412

## Description

### BACKGROUND OF THE INVENTION

### 1. Field of Disclosure

Aspects of the present disclosure relate generally to data centers containing racks and enclosures used to house data processing, networking and telecommunications equipment, and more particularly to cooling systems and methods used to cool equipment housed by such racks and enclosures.

### 2. Discussion of Related Art

Equipment enclosures or racks for housing electronic equipment, such as data processing, networking and telecommunications equipment have been used for many years. Such racks are used to contain and to arrange the equipment in small wiring closets as well as equipment rooms and large data centers. In certain embodiments, an equipment rack can be an open configuration and can be housed within a rack enclosure, although the enclosure may be included when referring to a rack.

Over the years, a number of different standards have been developed to enable equipment manufacturers to design rack mountable equipment that can be mounted in standard racks manufactured by different manufacturers. A standard rack typically includes front mounting rails to which multiple units of electronic equipment, such as servers, CPUs and telecommunication equipment, are mounted and stacked vertically within the rack. An exemplary industry standard rack is approximately six to six-and-a-half feet high, by about twenty-four inches wide, and about forty inches deep. Such a rack is commonly referred to as a "nineteen inch" rack, as defined by the Electronics Industries Association's EIA-310-D standard. Nineteen inch racks are used extensively in data centers and other large facilities. With the proliferation of the Internet, it is not uncommon for a data center to contain hundreds of these racks. Further, with the ever decreasing size of computer equipment, and in particular, computer servers and blades, the number of electrical devices mounted in each rack has been increasing, raising concerns about adequately cooling the equipment.

Heat produced by rack-mounted equipment can have adverse effects on the performance, reliability and useful life of the equipment components. In particular, rack-mounted equipment, housed within an enclosure, may be vulnerable to heat build-up and hot spots produced within the confines of the enclosure during operation. The amount of heat generated by a rack of equipment is dependent on the amount of electrical power drawn by equipment in the rack during operation. In addition, users of electronic equipment may add, remove, and rearrange rack-mounted components as their needs change and new needs develop.

Previously, in certain configurations, data centers have been cooled by computer room air conditioner ("CRAC") units that are typically positioned around the periphery of the data center room. These CRAC units intake air from the fronts of the units and output cooler air upwardly toward the ceiling of the data center room. In other embodiments, the CRAC units intake air from near the ceiling of the data center room and discharge cooler air under a raised floor for delivery to the fronts of the equipment racks. In general, such CRAC units intake room temperature air (at about 72 °F) and discharge cold air (at about 55 °F), which is blown into the data center room and mixed with the room temperature air at or near the equipment racks. The rack-mounted equipment typically cools itself by drawing air along a front side or air inlet side of a rack, drawing the air through its components, and subsequently exhausting the air from a rear or vent side of the rack. The disclosures of EP 0025665 A1, US 2011/292600 A1 and US 2008/198549 A1 maybe helpful for understanding the present invention.

### BRIEF SUMMARY OF THE INVENTION

In one aspect of the disclosure a cooling unit comprises a cooling unit including at least one heat exchanger comprising an inlet for receiving coolant from a coolant supply and an outlet to exhaust coolant to a coolant return, an input line in fluid communication with the coolant supply and the inlet of the heat exchanger, an output line in fluid communication with the outlet of the heat exchanger and the coolant return, a transfer line comprising a pump configured to allow fluid communication from the output line to the input line, and a controller configured to operate the pump to control a flow rate of coolant delivered by the transfer line.

In some embodiments, the transfer line further comprises a valve.

In some embodiments, the cooling unit further includes a sensor configured to measure a characteristic of the coolant and the controller controls the flow rate of the coolant based on the characteristic In various embodiments, the sensor is a temperature sensor and the characteristic is a temperature of the coolant.

In some embodiments, the cooling unit further includes a humidity sensor configured to measure a dew point of air entering the cooling unit. In some embodiments, the flow rate is controlled so that the temperature of the coolant is maintained above the dew point of the air entering the cooling unit.

In some embodiments, the cooling unit further includes a bypass line configured to allow fluid communication from the input line to the output line. In some embodiments, the bypass line includes a three-way valve controlled by the controller. In various embodiments, the controller controls a flow rate of coolant delivered by the bypass line based on a temperature of air cooled by the cooling unit.

In some embodiments, the output line includes a flow meter. In various embodiments, the input line includes a first temperature sensor and the output line includes a second temperature sensor. In some embodiments, the controller is configured to calculate a cooling capacity based, at least in part, on information from the flow meter, the first temperature sensor, and the second temperature sensor.

In various embodiments, the input line includes a shutoff valve.

Another aspect of the disclosure is directed to a method of cooling warm air. In one embodiment, the method includes positioning a cooling unit in a data center, drawing relatively warm air into the cooling unit, providing coolant to a heat exchanger via an input line, exhausting coolant from the heat exchanger via an output line, operating a pump to control a flow rate of coolant from the output line to the input line via a transfer line comprising the pump, and moving the warm air over the heat exchanger positioned within a housing of the cooling unit.

In some embodiments, a temperature of the coolant is maintained above a dew point of the relatively warm air.

### BRIEF DESCRIPTION OF THE DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a perspective view of a cooling unit of an embodiment of the present disclosure;
FIG. 2 is a perspective view of the cooling unit with panels removed from the cooling unit to better illustrate components of the cooling unit;
FIG. 3 is an enlarged perspective view of components of the cooling unit;
FIG. 4 is a schematic diagram of the cooling unit;
FIG. 5 is a schematic diagram of a cooling system having a cooling distribution unit and a plurality of cooling units; and
FIG. 6 is another schematic diagram of a cooling system.

### DETAILED DESCRIPTION OF THE INVENTION

At least one embodiment of the present disclosure is directed to a modular cooling unit that is selectively positionable to cool electronic equipment housed within equipment enclosures or racks of a data center. As used herein, "enclosures" and "racks" are used to describe apparatus designed to support electronic equipment. Such a cooling system is capable of employing one or more cooling units on an as needed basis to provide localized cooling within the data center. Specifically, multiple cooling units may be interspersed in a row of equipment racks to more efficiently cool the data center. The circulation path of warm air generated by the electronic equipment is greatly reduced, thereby nearly eliminating the mixing of hot and cold air within the data center.

Data centers are typically large rooms designed, in certain instances, to house hundreds of electronic equipment racks arranged in rows within the data center. The rows of equipment racks are arranged in such a manner that there are cold aisles and hot aisles. The cold aisles provide access to the fronts of the enclosures where the electronic equipment is typically accessed. The hot aisles provide access to the backs of the equipment racks. As requirements change, the number of equipment racks may be increased or decreased depending on the functional requirements of the data center. At least one embodiment of the cooling unit of the present disclosure is modular and scalable. Also, although relatively large data centers are discussed as an intended use for such a cooling system incorporating cooling units, as mentioned above, the cooling units of the present disclosure may be employed in smaller rooms on a smaller scale.

In some embodiments, the cooling unit includes a heat exchanger that cools air that passes through the cooling unit. The heat exchanger may receive coolant through an inlet and exhaust coolant through an outlet. The inlet may be connected to an input line, such as a pipe, which connects the heat exchanger to a coolant supply. The outlet may be connected to an output line, such as a pipe, which connects the heat exchanger to a coolant return. The input line and the output line may have a transfer line, such as a pipe, including a component, such as a pump, that allows coolant to pass from the output line to the input line. In some embodiments, the pump transfers relatively warm coolant from the output line to mix with relatively cool coolant in the input line to maintain a temperature of the coolant above a threshold. For example, the coolant may be maintained at a temperature above a dew point of the air in which the cooling unit is deployed. By maintaining the temperature of the coolant above the dew point, a building up of condensate may be avoided on fin coils of the heat exchanger. With substantially little condensate on the fin coils, the fin coils can be placed in a horizontal configuration in the heat exchanger, which may allow for fin coils that are larger in size and heat transfer area to fit in the cooling unit. Further, with substantially little condensate, the cooling unit may operate without components designed to remove condensate, such as drain pipes and condensate pumps, and the cooling unit may operate with less risk of condensate being blown out of the cooling unit onto equipment that may be sensitive to water exposure.

In certain embodiments, the cooling unit may be one-half the width of a standard size nineteen inch equipment rack, e.g., twelve inches in width, and may be modular so that the cooling unit may be inserted into a row of equipment racks in a matter of minutes by data center employees who have no particular heating and cooling training or specialization. The modular nature of the cooling system allows the user to optimize the location of each cooling unit. Thus, the cooling system may be employed and redeployed for maximum efficiency and use within the data center.

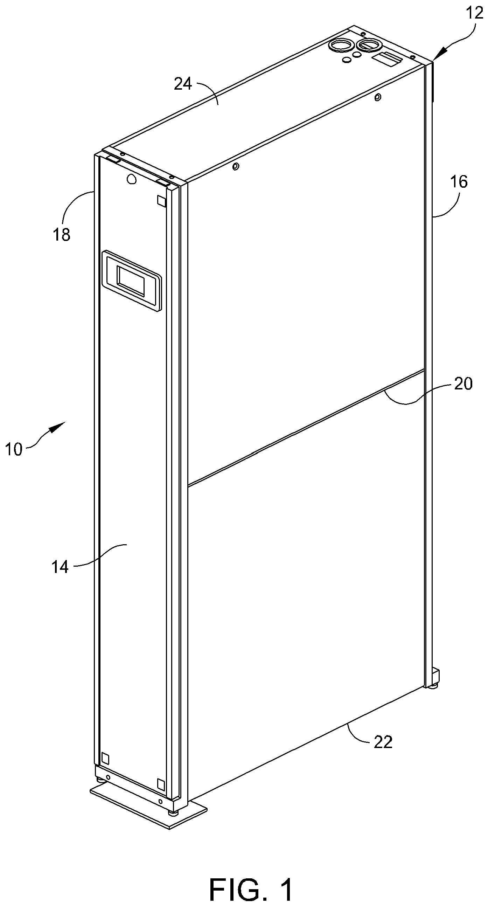

Turning now to the drawings, in order to address the heat build-up and hot spots within the data center, and to address climate control issues within the data center in general, a modular cooling unit, generally indicated at 10, is provided in some embodiments. As shown in FIG. 1, the cooling unit 10 includes a housing generally indicated at 12 that may be constructed similarly to a housing of an equipment rack. Like an equipment rack, the housing 12 of the cooling unit 10 is a rectangular structure having a front 14, a back 16, two sides 18, 20, a bottom 22 and a top 24 defined by a frame constructed of vertical and horizontal support members. Covers or panels (not designated) are provided to cover the front 14, back 16, sides 18, 20, top 24 and bottom 22. As will be disclosed in greater detail below, the cooling unit 10 is configured to accommodate and house cooling equipment, and, in some embodiments, may be conveniently broken down and disassembled for transport or storage with the aid of hand tools only.

As shown in FIG. 1, in some embodiments, the housing 12 of the cooling unit 10 has a width that is approximately one-half the width of the equipment rack. As stated above, a standard nineteen inch rack has a width of approximately twenty-four inches. Thus, the width of the housing 12 of the cooling unit 10 is approximately twelve inches. This sizing enables the person configuring the data center to position a cooling unit or multiple cooling units in between equipment racks while being able to maintain equivalent spacing among several rows. The narrower width of the cooling unit 10 also takes up less space, and, coupled with the modular and movable nature of the cooling unit, enables the cooling unit to be conveniently placed between two equipment racks in an easily scalable manner.

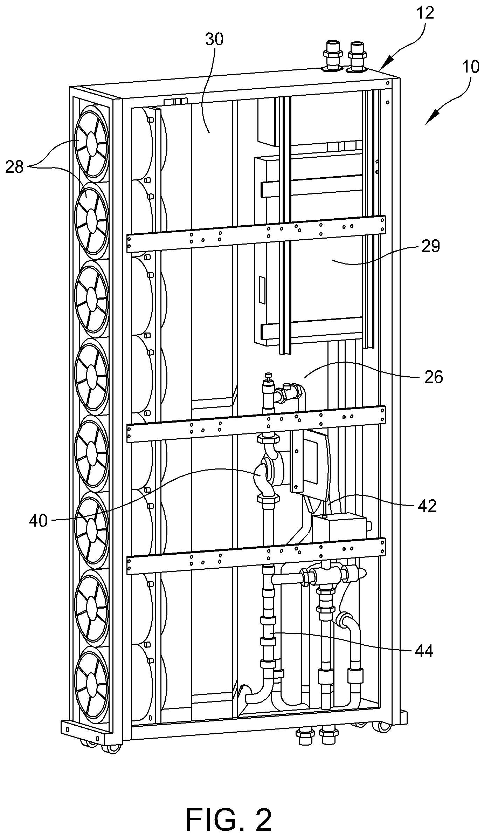

As discussed above, the cooling unit 10 may include one or more side panels attachable to the frame of the housing 12 to cover the sides 18, 20 of the cooling unit. Similarly, the housing 12 may further include a front panel to cover portions of the front 14 of the cooling unit 10. The back 16 of the housing 12 of the cooling unit 10 may include a back panel suitably secured to the frame constituting the housing. The back panel enables an operator of the data center to access an interior region of the cooling unit 10. A top panel may further be provided to cover the top 24 of the cooling unit 10. In one embodiment, the front, side and back panels may be suitably secured, e.g., by suitable screw fasteners, to the frame of the cooling unit. In another embodiment, fasteners capable of manipulation by hand, e.g., thumb screws or quarter-turn fasteners, may be employed to attach the panels to the frame. The housing 12 of the cooling unit 10 creates a space within an interior region 26 (see FIG. 2) of the cooling unit to allow components of a cooling system to be housed within the cooling unit. In certain embodiments, the front panel and the back panel may be secured to the frame of the housing of the cooling unit by quarter-turn latches to enable easy attachment and removal of the panels so that the interior region 26 may be quickly accessed. The components and configuration of such a cooling system shall be described in greater detail as the description of the cooling system proceeds.

As shown in FIGS. 1 and 2, the front 14 of the housing of the cooling unit 10 has a number of variable speed fans (e.g., eight), each indicated at 28, that are adapted to draw air from the back 16 of the cooling unit to the front 14 of the cooling unit. In some embodiments, the air may be passed through one or more filters (not shown) disposed within the interior region 26 of the cooling unit 10 to purify the air. In one embodiment, the fans 28 may be assembled and wired within the housing 12 of the cooling unit 10 such that a fan is removed by removing screws and sliding the fan out of a receptacle (not shown) formed in the housing 12 of the cooling unit 10. The electrical power provided to each fan 28 may be connected and disconnected by a suitable connector, such as a blindmate connector. The arrangement is such that the fans 28 are "hot swappable" based on voltage requirements as well as their easy removal from the receptacle and blindmate connector. In some embodiments, a controller 29 may be configured to monitor the operation of each fan 28 so as to predict the failure of a fan based on power draw variances of the fan. The controller 29 is also configured to control the operation of the other working components of the cooling unit 10. Although the fans 28 are shown to be located at the front 14 of the cooling unit 10 illustrated in FIG. 1, the fans may alternatively be provided at the back 16 of the cooling unit 10 to blow air into the interior region 26 of the cooling unit 10.

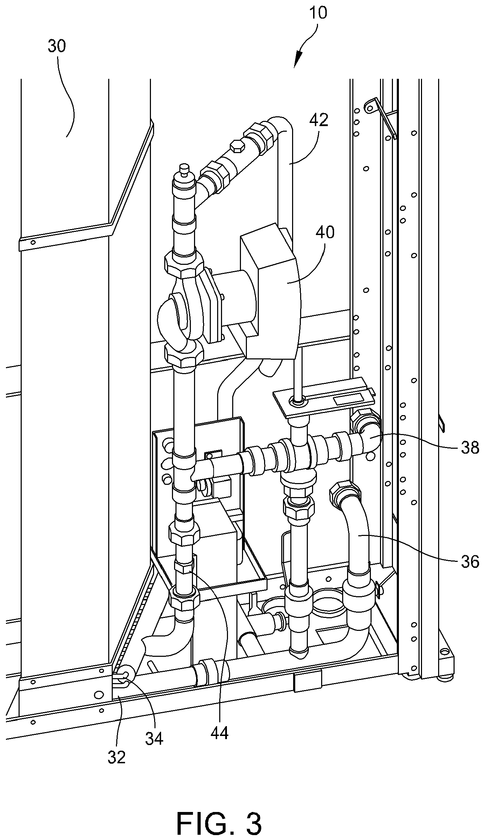

Referring to FIGS. 2 and 3, in some embodiments, the cooling unit 10 includes at least one heat exchanger 30. The heat exchanger 30 includes fin coils, through which coolant flows. The coolant enters the heat exchanger 30 at an inlet 32 and exits the heat exchanger 30 at an outlet 34. In some embodiments, the coolant is chilled water, but any appropriate coolant may be used. The chilled water enters the heat exchanger 30 and flows through the fin coils. The fin coils include fins on the exterior that can absorb heat from warm air passing through the cooling unit 10. Thus, the coolant in the fin coils is heated while the air passing through the cooling unit 10 is cooled. The warmed water exits the heat exchanger 30 to return to a coolant return.

The cooling unit 10 includes an input line 36 that supplies chilled water to the heat exchanger 30 through the inlet 32, and an output line 38 that exhausts warmed water from the heat exchanger 30 from the outlet 34. The cooling unit 10 includes a transfer line 42 including a component, such as a pump 40, that allows coolant to flow from the output line 38 to the input line 36. Thus, water warmed by warm air passing through the heat exchanger 30 may be pumped into the input line 36 to mix with the chilled water. In some embodiments, the input line 36, output line 38, and transfer line 42 are copper-tube pipes, which allow fluid communication between connected components, but any appropriate materials may be used to construct the lines.

In some embodiments, the controller 29 is also configured to control the operation of the pump 40. The controller 29 can adjust the flow rate of the water pumped by the pump 40 depending on a temperature of the chilled water in the input line 36 as well as a dew point of the air to minimize the formation of condensate on the fin coils of the heat exchanger 30. In some embodiments, the input line 36 includes a temperature sensor to monitor the temperature of the chilled water in the input line 36. The temperature sensor may be located at or near the inlet 32 so that the measured temperature includes the mixed warm water and reflects the temperature of the water as it enters the fin coils. In some embodiments, the cooling unit 10 includes a humidity sensor to monitor the dew point of the air around the fin coils. Using the measured temperature of the chilled water and the measured dew point, the controller 29 can adjust the flow of the warmed water into the chilled water to maintain a temperature above the dew point to minimize the formation of condensate on the fin coils. The flow rate of the warmed water from the fin coils may be measured by a flow meter 44 connected to the output line 38.

In some embodiments, the fins of the fin coils of the heat exchanger 30 are arranged in a horizontal configuration. The horizontal configuration of the fins may allow for larger fins and a greater heat transfer area to fit in the space available in a half-rack cooling unit. In some embodiments, minimizing condensate allows for a more simplified piping design and streamlining of components in the cooling unit 10. For example, some traditional cooling units include one or more of a condensate pump, float switch, drain pan, and drain pipe, which the cooling unit 10 may operate without.

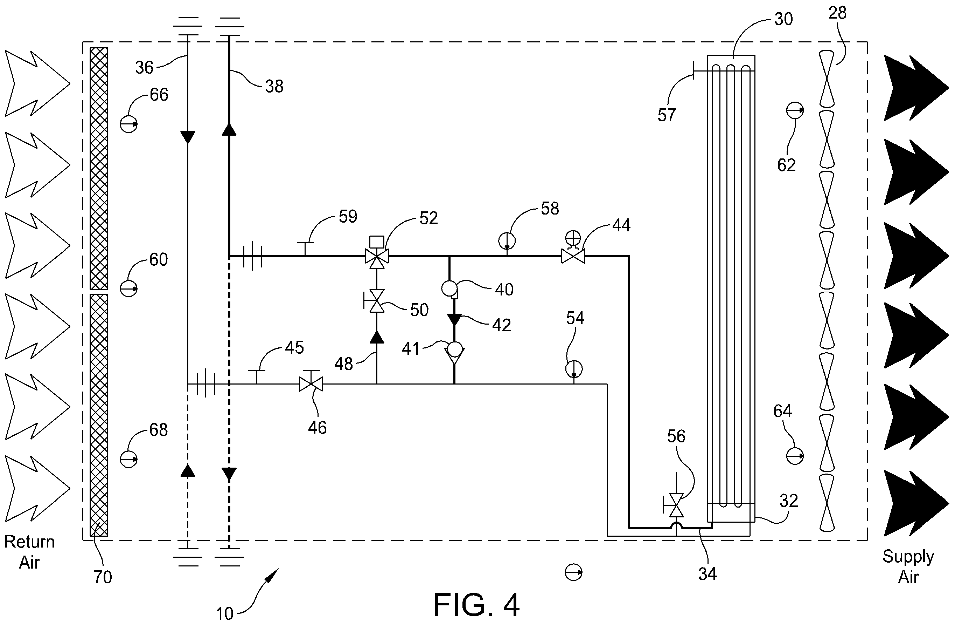

FIG. 4 is a schematic diagram showing an example flow of coolant through the cooling unit 10. In some embodiments, the coolant, such as chilled water, enters the cooling unit 10 from a coolant supply via the input line 36. The coolant passes through a valve 46, which may be a manual valve that may be used to stop the flow of coolant further into the cooling unit 10, for example, if the cooling unit needs repair or maintenance.

The input line 36 connects to a bypass line 48, which allows chilled water to flow from the input line 36 to the output line 38. The bypass line 48 includes a valve 50 and connects to the output line 38 via a three-way valve 52. The valve 50 of the bypass line 48 may be closed to generate a fixed water pressure or opened to generate a fixed flow rate in the input line 36. In some embodiments, the controller 29 controls the flow of chilled water through the three-way valve 52 based on a temperature of cooled air. For example, cooled air temperature sensors 62, 64 may be placed in the cooling unit 10 between the heat exchanger 30 and the fans 28 to measure the temperature of air exiting the cooling unit 10 after it has been cooled by the heat exchanger 30. If the temperature of the cooled air rises, and/or more cooling of the air is desired, the three-way valve 52 may be adjusted to allow less chilled water into the output line 38 and thus direct more of the chilled water into the heat exchanger 30 via the input line 36. Conversely, the three-way valve 52 may be adjusted to allow more chilled water into the output line 38 if less cooling of the air is desired.

In some embodiments, the input line 36 connects to a transfer line 42. The transfer line 42 includes a pump 40, which pumps warmed water from the output line 38 back into the input line 36. The transfer line 42 may also include a one-way valve 41 to prevent backflow of chilled water from the input line 36 to the output line 38 via the transfer line 42. In some embodiments, the controller 29 controls the operation of the pump 40 based on the temperature of the chilled water as it enters the heat exchanger 30. For example, a chilled water temperature sensor 54 may be configured to detect the temperature of the chilled water as it enters the heat exchanger 30. In some embodiments, the cooling unit 10 also includes a humidity sensor 60, which detects the dew point of the air entering the cooling unit 10. The pump 40 controls the flow rate of warmed water from the output line 38 into the input line 36 to maintain the temperature of the chilled water above the dew point by increasing the temperature of the chilled water as it mixes with the warmed water. For example, the dew point may be measured to be 15 degrees Celsius. The temperature of the chilled water as it enters the cooling unit 10 may be 7 degrees Celsius. In such a scenario, the controller 29 would then pump enough warmed water from the output line 38 into the input line 36 to raise the temperature of the chilled water to at least 15 degrees Celsius. In this way, the formation of condensate on the fin coils of the heat exchanger may be minimized when the warm air passes over the fin coils containing the chilled water. The controller 29 may adjust the speed of the pump 40 to change the flow rate of the warmed water as the controller 29 receives feedback from the chilled water temperature sensor 54 of the changing temperature of the chilled water. In some embodiments, the cooling unit 10 includes a warmed water temperature sensor 58, which detects the temperature of the warmed water as it exits the heat exchanger 30. The cooling unit 10 may also include a temperature sensor to detect the temperature of the chilled water as it enters the cooling unit 10, before it mixes with the warmed water. In some embodiments, the controller 29 may use information from these temperature sensors to calculate the desired speed of the pump 40 to introduce more warmed water into the line 36 containing chilled water thereby raising the temperature of the chilled water to at least the monitored dew point.

In some embodiments, the input line 36 includes a drain 56, which can be used to empty the input line 36. The input line 36 connects to the inlet 32 of the heat exchanger 30, where the chilled water enters the heat exchanger 30. The chilled water flows through fin coils of the heat exchanger 30, and the warm air that enters the cooling unit 10 is cooled. In some embodiments, the heat exchanger 30 includes an air breathing service wall 57, which expels air from the fin coils. The chilled water is warmed by the warm air flowing over the heat exchanger and exits the heat exchanger 30 at the outlet 34 as warmed water. The outlet 34 is connected to the output line 38, which carries the warmed water to a coolant return.

In some embodiments, the output line 38 includes a flow meter 44, which measures the flow rate of the warmed water flowing from the heat exchanger 30. The output line 38 also includes the warmed water temperature sensor 58. The controller 29 may receive data from the warmed water temperature sensor 58, the chilled water temperature sensor 54, and the flow meter 44 to calculate a cooling capacity of the cooling unit 10. For example, the difference in temperature between the chilled water and the warmed water may be attributed to the heat transferred from the warm air, and thus cooled. The temperature difference and the flow rate may thus be used to calculate the cooling capacity using techniques known in the art. In some embodiments, the controller 29 adjusts parameters of the cooling unit 10 based on the calculated cooling capacity. For example, flow rates of the pump 40 or the three-way valve 52 or other components may be adjusted to raise or lower the cooling capacity as desired. Cooling capacity and other measurements may also be determined and/or adjusted using information received from warm air temperature sensors 66, 68, which detect the temperature of the air entering the cooling unit 10, and the cooled air temperature sensors 62, 64.

The output line 38 connects to the transfer line 42 and the pump 40 to allow warmed water to flow into the input line 36 as described above. The output line 38 is also connected to an input and an output of the three-way valve 52, which allows chilled water to flow from the bypass line 48 into the output line 38 as described above. In some embodiments, the input line includes a service port 45, and the output line 38 includes a service port 59, which are used for leak testing.

In some embodiments, the cooling unit 10 includes a filter 70, through which air passes as the air enters the cooling unit 10. The warm air is pulled through the cooling unit 10 by the fans 28 to the heat exchanger 30, where the warm air discharges heat to the chilled water in the fin coils. The fans 28 drive the movement of cooled air from the heat exchanger 30 out of the cooling unit 10 and back into the environment.

Although the housing 12 of the cooling unit 10 is illustrated in the drawings as being one-half the width of an equipment rack, the cooling unit may be sized to any desired configuration. The provision of a cooling unit 10 having one-half the industry-standard width improves the scalability of the cooling unit. However, it is contemplated, for example, to configure the housing 12 to have the same width as the housing of the equipment rack. In such an embodiment, the cooling unit 10 may be configured with cooling system components that enhances the cooling capacity of the cooling unit. This configuration may be desirable for hot spots within the data center.

In certain embodiments, the controller 29 may be employed to control the operation of the cooling system, and specifically, in certain embodiments, the operation of the cooling unit 10 and components of the cooling unit 10 such as the pump 40 and the three-way valve 52. In one embodiment, the controller may be a dedicated unit to the cooling system. In another embodiment, the controller may be provided as part of an integrated data center control and monitoring system. In yet another embodiment, each cooling unit 10 may be independently operable by a controller provided in the cooling unit that is in communication with controllers of the other cooling units. Notwithstanding the particular configuration, the controller is designed to control the independent operation of the cooling unit within the data center.

For example, the controller may be configured to identify the failure or inability of the particular cooling unit to cool the air, and to increase the cooling capacity of the cooling unit or cooling units located near the failed cooling unit. In another embodiment, one cooling unit may operate as the main or master unit and the other cooling units operate as subservient units that operate under the control of the main unit. In this embodiment, the main cooling unit may be manipulated by the data center operator to control the entire cooling system. For example, the controller may be configured to receive information from the equipment racks so as to determine the amount of power being drawn by each equipment rack. With this knowledge, the controller may be configured to increase the cooling capacity of certain cooling units within the cooling system based on the energy drawn by the equipment racks.

In some embodiments, the controller may embody only controller unit provided in the cooling units that communicate with one another over a controller area network (CAN) Bus. In other embodiments, a master controller may be provided to control the operation of the controller units. Changes to the environmental conditions, such as the temperature of the data center, results in changes of inputs including the temperature of the refrigerant flowing into and out of the cooling unit.

While the output line 38 has been referred to as a single line, it should be understood that the flow rates of fluid in the output line 38 can change as the fluid branches into and from other lines, such as the transfer line 42 and the bypass line 48. While the flow meter 44 has been described as placed on the output line 38 before the transfer line 42 to measure the flow rate of water exiting the heat exchanger 30, flow meters can additionally or alternatively be placed at other points on the output line 38 to measure different flow rates.

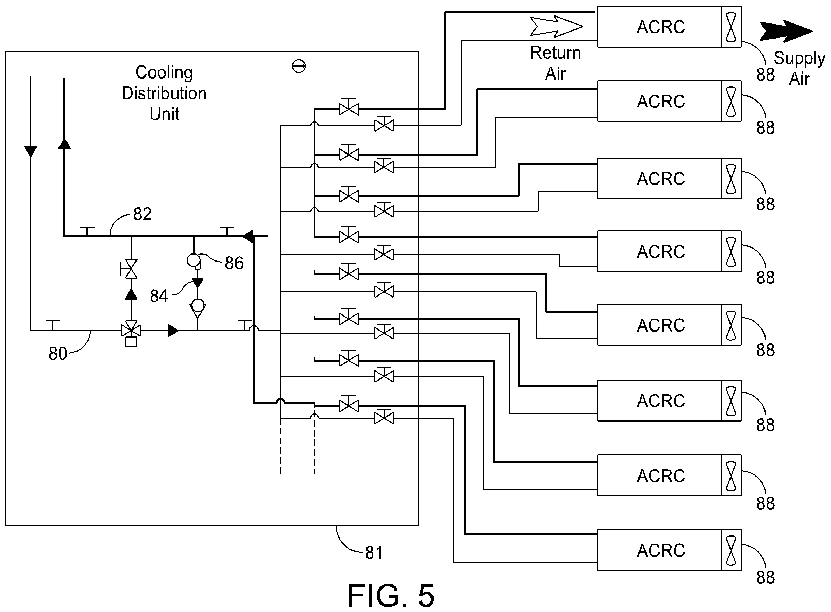

While the input line 36, output line 38, and transfer line 42 have been described as components of an individual cooling unit 10, in some embodiments, the input line 36, output line 38, and transfer line 42 are external to the individual cooling unit and in communication with one or more cooling units. For example, FIG. 5 shows an example embodiment of a cooling system. The cooling system includes a cooling distribution unit 81, where a transfer line 84 allows warmed water to flow from an output line 82 to an input line 80. As described above, the transfer line includes a component, such as a pump 86, that moves warmed water from the output line 82 to the input line 80. The input line 80 transfers chilled water to one or more individual cooling units 88, which include heat exchangers configured to cool air in which the cooling units 88 are deployed.

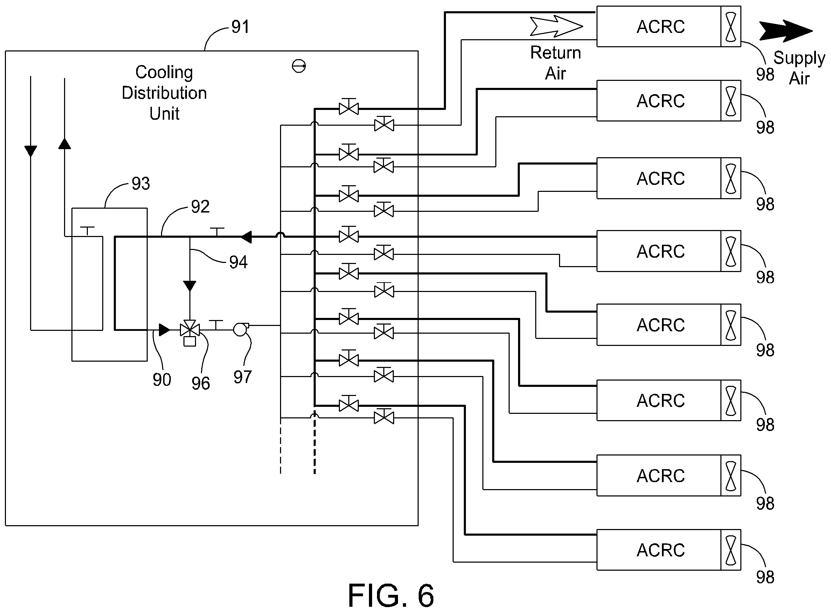

FIG. 6 shows another example embodiment of a cooling system including a cooling distribution unit 91. The cooling distribution unit 91 includes an input line 90, an output line 92, and a transfer line 94. In some embodiments, the component included on the transfer line 94 is a valve, such as a three-way valve 96, that controls the flow rate of the warmed water from the transfer line 94 to the input line 90. In some embodiments, the cooling distribution unit 91 includes a plate heat exchanger 93 that chills the warmed water returned from individual cooling units 98. In some embodiments, the cooling distribution unit 91 includes a component, such as a pump 97, which drives the chilled water to recycle in the system.

## Claims

1. A cooling unit (10) comprising:
at least one heat exchanger (30) comprising an inlet (32) for receiving coolant from a coolant supply and an outlet (34) to exhaust coolant to a coolant return;
an input line (36) in fluid communication with the coolant supply and the inlet (32) of the heat exchanger (30);
an output line (38) in fluid communication with the outlet (34) of the heat exchanger (30) and the coolant return: **characterised in that** the cooling unit comprises:
a transfer line (42) comprising a pump (40) configured to allow fluid communication from the output line (38) to the input line (36); and
a controller (29) configured to operate the pump (40) to control a flow rate of coolant delivered by the transfer line (42).

2. The cooling unit (10) of claim 1, wherein the transfer line (42) further comprises a valve (41).

3. The cooling unit (10) of claim 1, further comprising a sensor (54) configured to measure a characteristic of the coolant and wherein the controller (29) operates the pump (40) to control the flow rate of the coolant based on the characteristic.

4. The cooling unit (10) of claim 3, wherein the sensor (54) is a temperature sensor (54) and the characteristic is a temperature of the coolant.

5. The cooling unit (10) of claim 4, further comprising a humidity sensor (60) configured to measure a dew point of air entering the cooling unit (10).

6. The cooling unit (10) of claim 5, wherein the flow rate is controlled so that the temperature of the coolant is maintained above the dew point of the air entering the cooling unit (10).

7. The cooling unit (10) of claim 1, further comprising a bypass line (48) configured to allow fluid communication from the input line (36) to the output line (38).

8. The cooling unit (10) of claim 7, wherein the bypass line (48) includes a three-way valve (52) controlled by the controller (29).

9. The cooling unit (10) of claim 8, wherein the controller (29) controls a flow rate of coolant delivered by the bypass line (48) based on a temperature of air cooled by the cooling unit (10).

10. The cooling unit (10) of claim 1, wherein the output line (38) includes a flow meter (44).

11. The cooling unit (10) of claim 10, wherein the input line (36) includes a first temperature sensor (54) and the output line (38) includes a second temperature sensor (58).

12. The cooling unit (10) of claim 11, wherein the controller (29) is configured to calculate a cooling capacity based, at least in part, on information from the flow meter (44), the first temperature sensor (54), and the second temperature sensor (58).

13. The cooling unit (10) of claim 1, wherein the input line (36) includes a shutoff valve (46).

14. A method of cooling warm air, the method comprising:
positioning a cooling unit (10) in a data center;
drawing relatively warm air into the cooling unit (10);
providing coolant to a heat exchanger (30) via an input line (36);
exhausting coolant from the heat exchanger (30) via an output line (38);
and moving the warm air over the heat exchanger (30) positioned within a housing (12) of the cooling unit (10); **characterised by** operating a pump (40) to control a flow rate of coolant from the output line (38) to the input line (36) via a transfer line (42) comprising the pump (40).

## Patentansprüche

1. Eine Kühleinheit (10), beinhaltend:
mindestens einen Wärmeaustauscher (30), der einen Einlass (32) zum Erhalten von Kühlmittel von einer Kühlmittelversorgung und einen Auslass (34) zum Abgeben von Kühlmittel an einen Kühlmittelrücklauf beinhaltet;
eine Eingangsleitung (36) in Fluidkommunikation mit der Kühlmittelversorgung und dem Einlass (32) des Wärmeaustauschers (30);
eine Ausgangsleitung (38) in Fluidkommunikation mit dem Auslass (34) des Wärmeaustauschers (30) und dem Kühlmittelrücklauf, **dadurch gekennzeichnet, dass** die Kühleinheit Folgendes beinhaltet:
eine Transferleitung (42), die eine Pumpe (40) beinhaltet, welche konfiguriert ist, eine Fluidkommunikation von der Ausgangsleitung (38) zu der Eingangsleitung (36) zu ermöglichen; und
eine Steuervorrichtung (29), die konfiguriert ist, die Pumpe (40) zum Steuern einer Flussrate des durch die Transferleitung (42) zugeführten Kühlmittels zu betreiben.

2. Kühleinheit (10) gemäß Anspruch 1, wobei die Transferleitung (42) ferner ein Ventil (41) beinhaltet.

3. Kühleinheit (10) gemäß Anspruch 1, ferner beinhaltend einen Sensor (54), der konfiguriert ist, eine Eigenschaft des Kühlmittels zu messen, und wobei die Steuervorrichtung (29) die Pumpe (40) zum Steuern der Flussrate des Kühlmittels auf der Basis der Eigenschaft betreibt.

4. Kühleinheit (10) gemäß Anspruch 3, wobei der Sensor (54) ein Temperatursensor (54) ist und die Eigenschaft eine Temperatur des Kühlmittels ist.

5. Kühleinheit (10) gemäß Anspruch 4, ferner beinhaltend einen Feuchtigkeitssensor (60), der konfiguriert ist, einen Taupunkt von in die Kühleinheit (10) eintretender Luft zu messen.

6. Kühleinheit (10) gemäß Anspruch 5, wobei die Flussrate so gesteuert wird, dass die Temperatur des Kühlmittels oberhalb des Taupunkts der in die Kühleinheit (10) eintretenden Luft gehalten wird.

7. Kühleinheit (10) gemäß Anspruch 1, ferner beinhaltend eine Umgehungsleitung (48), die konfiguriert ist, eine Fluidkommunikation von der Eingangsleitung (36) zu der Ausgangsleitung (38) zu ermöglichen.

8. Kühleinheit (10) gemäß Anspruch 7, wobei die Umgehungsleitung (48) ein von der Steuervorrichtung (29) gesteuertes Dreiwegventil (52) umfasst.

9. Kühleinheit (10) gemäß Anspruch 8, wobei die Steuervorrichtung (29) eine Flussrate des von der Umgehungsleitung (48) zugeführten Kühlmittels auf der Basis einer Temperatur der von der Kühleinheit (10) gekühlten Luft steuert.

10. Kühleinheit (10) gemäß Anspruch 1, wobei die Ausgangsleitung (38) einen Durchflussmesser (44) umfasst.

11. Kühleinheit (10) gemäß Anspruch 10, wobei die Eingangsleitung (36) einen ersten Temperatursensor (54) umfasst und die Ausgangsleitung (38) einen zweiten Temperatursensor (58) umfasst.

12. Kühleinheit (10) gemäß Anspruch 11, wobei die Steuervorrichtung (29) konfiguriert ist, eine Kühlkapazität mindestens zum Teil auf der Basis von Informationen von dem Durchflussmesser (44), dem ersten Temperatursensor (54) und dem zweiten Temperatursensor (58) zu berechnen.

13. Kühleinheit (10) gemäß Anspruch 1, wobei die Eingangsleitung (36) ein Absperrventil (46) umfasst.

14. Ein Verfahren zum Kühlen warmer Luft, wobei das Verfahren Folgendes beinhaltet:
Positionieren einer Kühleinheit (10) in einem Datenzentrum;
Saugen relativ warmer Luft in die Kühleinheit (10);
Bereitstellen eines Kühlmittels für einen Wärmeaustauscher (30) über eine Eingangsleitung (36);
Abgeben von Kühlmittel aus dem Wärmeaustauscher (30) über eine Ausgangsleitung (38); und
Bewegen der warmen Luft über den Wärmeaustauscher (30), der innerhalb eines Gehäuses (12) der Kühleinheit (10) positioniert ist; **gekennzeichnet durch** das Betreiben einer Pumpe (40) zum Steuern einer Flussrate von Kühlmittel aus der Ausgangsleitung (38) zu der Eingangsleitung (36) über eine Transferleitung (42), welche die Pumpe (40) beinhaltet.

## Revendications

1. Une unité de refroidissement (10) comprenant :
au moins un échangeur de chaleur (30) comprenant un orifice d'entrée (32) pour recevoir du réfrigérant en provenance d'une alimentation en réfrigérant et un orifice de sortie (34) pour évacuer le réfrigérant vers un retour de réfrigérant ;
une conduite d'entrée (36) en communication fluidique avec l'alimentation en réfrigérant et l'orifice d'entrée (32) de l'échangeur de chaleur (30) ;
une conduite de sortie (38) en communication fluidique avec l'orifice de sortie (34) de l'échangeur de chaleur (30) et le retour de réfrigérant ; **caractérisée en ce que** l'unité de refroidissement comprend :
une conduite de transfert (42) comprenant une pompe (40) configurée pour permettre une communication fluidique de la conduite de sortie (38) à la conduite d'entrée (36) ; et
un dispositif de commande (29) configuré pour actionner la pompe (40) afin de commander un débit de réfrigérant délivré par la conduite de transfert (42).

2. L'unité de refroidissement (10) de la revendication 1, dans laquelle la conduite de transfert (42) comprend en outre une vanne (41).

3. L'unité de refroidissement (10) de la revendication 1, comprenant en outre un capteur (54) configuré pour mesurer une caractéristique du réfrigérant et dans laquelle le dispositif de commande (29) actionne la pompe (40) afin de commander le débit du réfrigérant sur la base de la caractéristique.

4. L'unité de refroidissement (10) de la revendication 3, dans laquelle le capteur (54) est un capteur de température (54) et la caractéristique est une température du réfrigérant.

5. L'unité de refroidissement (10) de la revendication 4, comprenant en outre un capteur d'humidité (60) configuré pour mesurer un point de rosée d'air entrant dans l'unité de refroidissement (10).

6. L'unité de refroidissement (10) de la revendication 5, dans laquelle le débit est commandé de manière à maintenir la température du réfrigérant au-dessus du point de rosée de l'air entrant dans l'unité de refroidissement (10).

7. L'unité de refroidissement (10) de la revendication 1, comprenant en outre une conduite de dérivation (48) configurée pour permettre une communication fluidique de la conduite d'entrée (36) à la conduite de sortie (38).

8. L'unité de refroidissement (10) de la revendication 7, dans laquelle la conduite de dérivation (48) inclut une vanne à trois voies (52) commandée par le dispositif de commande (29).

9. L'unité de refroidissement (10) de la revendication 8, dans laquelle le dispositif de commande (29) commande un débit de réfrigérant délivré par la conduite de dérivation (48) sur la base d'une température d'air refroidi par l'unité de refroidissement (10).

10. L'unité de refroidissement (10) de la revendication 1, dans laquelle la conduite de sortie (38) inclut un débitmètre (44).

11. L'unité de refroidissement (10) de la revendication 10, dans laquelle la conduite d'entrée (36) inclut un premier capteur de température (54) et la conduite de sortie (38) inclut un deuxième capteur de température (58).

12. L'unité de refroidissement (10) de la revendication 11, dans laquelle le dispositif de commande (29) est configuré pour calculer une capacité de refroidissement sur la base, au moins en partie, d'informations provenant du débitmètre (44), du premier capteur de température (54), et du deuxième capteur de température (58).

13. L'unité de refroidissement (10) de la revendication 1, dans laquelle la conduite d'entrée (36) inclut une vanne d'arrêt (46).

14. Un procédé de refroidissement d'air chaud, le procédé comprenant :
le positionnement d'une unité de refroidissement (10) dans un centre de données ;
l'aspiration d'air relativement chaud dans l'unité de refroidissement (10) ;
la fourniture de réfrigérant à un échangeur de chaleur (30) par l'intermédiaire d'une conduite d'entrée (36) ;
l'évacuation de réfrigérant de l'échangeur de chaleur (30) par l'intermédiaire d'une conduite de sortie (38) ; et
le déplacement de l'air chaud au-dessus de l'échangeur de chaleur (30) positionné à l'intérieur d'un boîtier (12) de l'unité de refroidissement (10) ; **caractérisé par** l'actionnement d'une pompe (40) pour commander un débit de réfrigérant de la conduite de sortie (38) à la conduite d'entrée (36) par l'intermédiaire d'une conduite de transfert (42) comprenant la pompe (40).
